# EUROPEAN PATENT APPLICATION

(11) **EP 4 610 837 A1**
(43) Date of publication of application: **03.09.2025**
(21) Application number: 24199509.1
(22) Date of filing: 10.09.2024
(51) Int. Cl.: G06F 13/366, G06F 13/40, G06F 13/42, G06F 13/38, H04L 12/40, H04L 12/403, H03K 19/0175

(54) **BI-DIRECTIONAL COMMUNICATION BASED CONTROL APPARATUS AND SYSTEM, AND BI-DIRECTIONAL COMMUNICATION INTERFACE**

(30) Priority: 28.02.2024 KR 20240028742
(71) Applicant: SAMSUNG SDI CO., LTD., Giheung-gu Yongin-si, Gyeonggi-do 17084 (KR)
(72) Inventor: Kim, Sung Jung, 16678 Suwon-si, Gyeonggi-do (KR)
(74) Representative: Gulde & Partner

(57) **Abstract**

The present disclosure relates to a bi-directional communication-based control apparatus and system, and a bi-directional communication interface. The technical problem to be solved provides topology capable of implementing hardwired contactor control using a single port (P) of a micro controller unit, MCU, (200) without being constrained by restrictions on the number of ports of the MCU (200) which may be required depending on design specifications of an electronic control unit, ECU, and a battery management system, BMS. To this end, the present disclosure provides a processor (100) that controls a target element (200, 300) according to a control signal applied to a communication bus (B) and causes state information of the target element (200, 300) according to a result of the control to be formed on a communication bus (B), the control signal being input and a state signal for forming the state information being output through a single bi-directional port (P) provided in the processor (200); and an arbitrator (300) that arbitrates first direction transmission of the control signal from the communication bus (B) to the bi-directional port (P) and second direction transmission of the state signal from the bi-directional port (P) to the communication bus (B).

## Description

### FIELD

Aspects of embodiments of the present disclosure relate to a communication interface between a battery management system (BMS) and a high-level controller.

### BACKGROUND

A battery management system (BMS) performs a function of managing charging and discharging performance of rechargeable batteries, such as secondary batteries, in real time to prevent malfunctions in the batteries. For example, a micro controller unit (MCU) of the BMS applied to vehicles operates to protect the batteries by turning a contactor (or relay) off in a situation where overvoltage occurs due to overcharging of the batteries.

To meet industry-required power interface module (PIM) requirements for a vehicle-level high controller (e.g., vehicle electronic control unit (ECU)) and a battery-level lower controller (e.g., BMS or MCU), due to the need for a redundancy design of contactor control, a pulse width modulation (PWM) control method utilizing hardwire is required in addition to a controller area network (CAN) communication control method.

The hardwired contactor control includes i) a process (monitoring phase) of applying a contactor control signal from a vehicle ECU to a PIM bus and monitoring, by a BMS, the contact control signal, and ii) a process (response phase) of applying contactor state information to the PIM bus under control of the BMS. In the monitoring phase, a PWM duty ratio of the control signal applied to the PIM bus is interpreted by a timer input module (TIM) of a generic timer module (GTM) that constitutes the MCU within the BMS, and the operation of the contactor is controlled according to the interpreted PWM duty ratio. Thereafter, in the response phase, the BMS transmits to the vehicle ECU the contactor state information by controlling the time t_{low} for which a signal level of the PIM bus is maintained at a low level through data input/output (DIO). For example, in the case of an open state of the contactor, t_{low} is controlled to 100 ms, and in the case of a closed state of the contactor, t_{low} is controlled to 150 ms.

When controlling the hardwired contactor, a TIM port is used in the monitoring phase and a DIO port is used in the response phase. In other words, two ports of the MCU are required to apply the hardwired contactor control. However, depending on the design specifications of the vehicle ECU and BMS, the number of ports of the MCU may be limited. For example, a situation may arise where some ports of the MCU should be designed as reserved ports.

The above information disclosed in this Background section is for enhancement of understanding of the background of the present disclosure, and therefore, it may contain information that does not constitute related (or prior) art.

### SUMMARY

The present invention provides a bi-directional communication based control apparatus and system capable of implementing hardwired contactor control, corresponding to the appended claims, using a single port of a micro controller unit (MCU) without being constrained by restrictions on the number of ports of the MCU which may be required depending on design specifications of an electronic control unit (ECU) and a battery management system (BMS), and a bi-directional communication interface.

However, objects that the present invention intends to achieve are not limited to the above-described objects and other objects that are not described may be clearly understood by those skilled in the art from the following description.

According to an embodiment of the present invention, a bi-directional communication-based control apparatus includes: a processor that controls a target element according to a control signal applied to a communication bus and causes state information of the target element according to a result of the control to be formed on the communication bus, the control signal being input and a state signal for forming the state information being performed being output through a single bi-directional port provided in the processor; and an arbitrator that arbitrates first direction transmission of the control signal from the communication bus to the bi-directional port and second direction transmission of the state signal from the bi-directional port to the communication bus.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a diagram illustrating a bi-directional communication based control system according to one embodiment of the present disclosure;
FIG. 2 is a diagram a circuit structure of an arbitrator in the bi-directional communication based control system according to the embodiment of the present disclosure; and
FIG. 3 is a diagram illustrating an example for describing an operation of the bi-directional communication based control system according to the embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure, where the scope is defined by the appended claims. Accordingly, it should be understood that there may be various modifications that can replace or modify the embodiments described herein at the time of filing this application, without departing from the scope of the appended claims.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc., may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc., as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

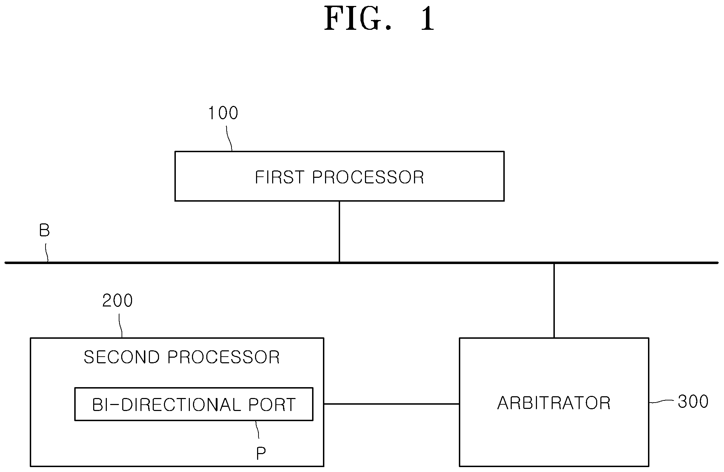

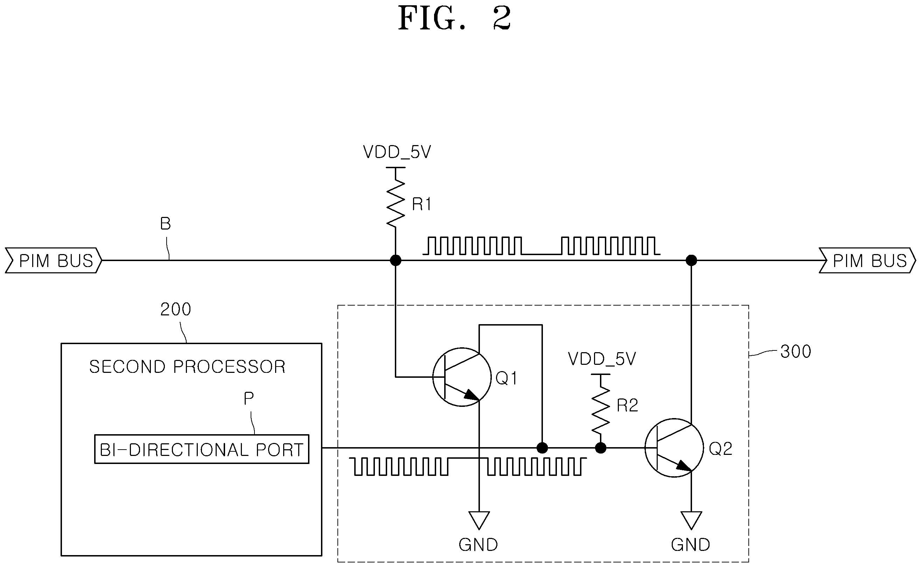

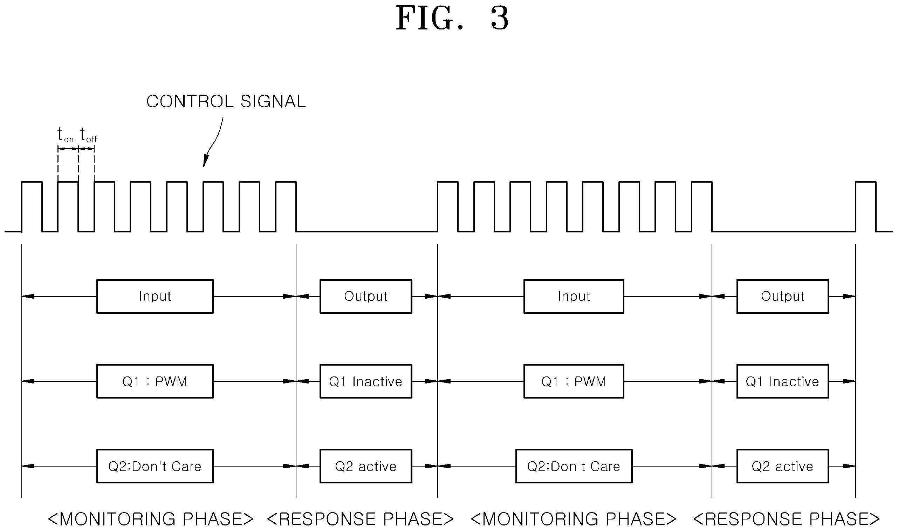

FIG. 1 is a diagram illustrating a bi-directional communication based control system according to one embodiment of the present disclosure. FIG. 2 is a diagram a circuit structure of an arbitrator in the bi-directional communication based control system according to the embodiment of the present disclosure. FIG. 3 is a diagram illustrating an example for describing an operation of the bi-directional communication based control system according to the embodiment of the present disclosure.

Referring to FIG. 1, the bi-directional communication based control system of the present embodiment may include a first processor 100, a communication bus B, a second processor 200, and an arbitrator 300. In the claims, the structure including the second processor 200 and the arbitrator 300 is recited as the "bi-directional communication based control apparatus", and the structure including a bi-directional port P of the second processor 200, which will be described below, and the arbitrator 300, is recited as a "bi-directional communication interface" but the claim terms are not so limited necessarily.

The first processor 100 may be implemented as a central processing unit (CPU) or a system on chip (SoC) and operate an operating system or applications to control a plurality of hardware and/or software components connected to the processor, thereby performing various data processing and operations. In the present embodiment, the first processor 100 may correspond to a vehicle electronic control unit (ECU) at a vehicle-level (i.e., applied to the vehicle), which functions as a high-level controller for the second processor 200, which will be described below, and may be configured to apply to a communication bus B a control signal for controlling a target element (e.g., contactor), which will be described below, and receive state information of the target element formed on the communication bus B by the second processor 200.

The communication bus B may correspond to a bus for data communication between the first and second processors 100 and 200, respectively, and specifically, correspond to a power interface module (PIM) bus that may be implemented as a hardwired bus provided depending on a redundancy design of target element control. The PIM bus can be implemented as a bus having an open collector structure based on a second transistor Q2 of the arbitrator 300, which will be described later. To this end, as illustrated in FIG. 2, a first pull-up resistor R1 may be connected to the communication bus B.

Like the first processor 100, the second processor 200 may be implemented as a CPU or an SoC, run an operating system or application to control a plurality of hardware and/or software components connected to the processor, and perform processing and calculating on various types of data (in this disclosure, the processor described in claims 1 to 11 corresponds to the second processor 200).

In the present embodiment, the second processor 200 may correspond to a battery management system (BMS) that controls a target element under the control of the first processor 100 which is a high-level controller, or a microcontroller unit (MCU) within the BMS. The second processor 200 may be configured to control the target element according to the control signal applied to the communication bus B by the first processor 100, and cause state information of the target element according to a target element control result to be formed on the communication bus B by outputting a state signal (described below) of the target element to the arbitrator 300. The target element to be controlled by the second processor 200 may correspond to a contactor (or relay) that turns on and turns off to protect a battery when the battery is charged and overvoltage of a battery system occurs (e.g., when battery cells, modules, or packs are overcharged and thus overvoltage occurs). However, implementation examples of the target element are not limited to the contactor, and the target element may be implemented as any of various elements within the range of elements capable of performing pulse width modulation (PWM) control by the second processor 200 (i.e., BMS or MCU).

A predefined protocol may be applied to data communication between the first and second processors 100 and 200 through the communication bus B, and the above-described protocol may correspond to the PIM requirements depending on the design specifications of the vehicle and battery system. As the protocol according to the PIM requirements is applied, the control signal applied to the communication bus B from the first processor 100 may be formed as a PWM signal, and the state information reflecting the state of the target element may be defined by the time when a signal level of the communication bus B is maintained at a low level.

As an example, the redundancy control of the target element through the communication bus B (i.e., hardwired PIM bus) may include i) a process (monitoring phase) of applying a control signal from the first processor 100 to the communication bus B and monitoring, by the second processor 200, the control signal, and ii) a process (response phase) of forming, by the second processor 200, the state information on the communication bus B. In the monitoring phase, the second processor 200 may receive the control signal applied to the communication bus B, interpret a PWM duty ratio, and control the target element according to the interpreted PWM duty ratio. Thereafter, in the response phase, the second processor 200 outputs the state signal to control the time t_{low} for which the signal level of the communication bus B is maintained at a low level, and thus the state information of the target element may be transmitted to the first processor 100. For example, in the case of an open state of the target element (e.g., contactor), t_{low} may be controlled to 100 ms, and in the case of a closed state of the target element, t_{low} may be controlled to 150 ms. Hereinafter, for a clear understanding of the present embodiment, the time at which the above-described monitoring phase is performed is defined as a first time period, and the time when the response phase following the monitoring phase is performed is defined as a second time period.

With reference to the second processor 200, inputting the control signal from the communication bus B and outputting the state signal for forming the state information may be performed through a single bi-directional port provided in the second processor 200. In the present embodiment, the arbitrator 300 is employed as a component to implement the signal input/output operations of the single bi-directional port P.

The arbitrator 300 may arbitrate a first direction transmission of the control signal from the communication bus B to the bi-directional port P (i.e., control signal input to the bi-directional port P), and a second direction transmission (i.e., state signal output from the bi-directional port P) from the bi-directional port to the communication bus B. As the arbitrator 300 is provided between the second processor 200 and the communication bus B, the second processor 200 may be applied to the communication bus B during the first time period (i.e., monitoring phase) and receive the control signal via the arbitrator 300 through the bi-directional port P, and output the state signal to the arbitrator 300 during the second time period (i.e., response phase) following the first time period, and cause the state information of the target element to be formed on the communication bus B.

The circuit structure of the arbitrator 300 is described in detail with reference to FIG. 2. As shown in FIG. 2, the arbitrator 300 may include a first transistor Q1, a second transistor Q2, and a second pull-up resistor R2. Here, the first transistor Q1 functions as an element that arbitrates the first direction transmission (i.e., control signal input) of the control signal from the communication bus B to the bi-directional port P of the second processor 200, and the second transistor Q2 functions as an element that arbitrates the second direction transmission (i.e., state signal output) of the state signal from the bi-directional port P of the second processor 200 to the communication bus B. The first and second transistors Q1 and Q2 may be implemented as a bipolar junction transistor (BJT).

Regarding a wiring structure of the arbitrator 300, in the case of the first transistor Q1, a base terminal may be connected to the communication bus B, a collector terminal may be connected to the bi-directional port P of the second processor 200, and an emitter terminal may be grounded. In the case of the second transistor Q2, the base terminal may be connected to the bi-directional port P of the second processor 200, the collector terminal may be connected to the communication bus B, and the emitter terminal may be grounded. One terminal of the second pull-up resistor R2 may be connected to an internal power supply (e.g., VDD_5V) and the other terminal may be connected to the bi-directional port P.

Based on the wiring structure of the arbitrator 300, the signal input/output operation of the bi-directional port P will be described with reference to FIG. 3 as follows.

First, the monitoring phase is associated with the first transistor Q1.

During the first time period corresponding to the monitoring phase, the control signal (PWM signal) for controlling the target element is applied from the first processor 100 to the communication bus B, and the control signal applied to the communication bus B is input to the base terminal of the first transistor Q1, and accordingly, the first transistor Q1 performs an on-off operation according to the PWM control signal.

During one PWM cycle of the control signal, the first transistor Q1 is turned on at the time tₒₙ when the control signal has a high level, and the input/output line connected to the bi-directional port P is grounded by the turn-on operation of the first transistor Q1, so the low level signal is input to the bi-directional port. At the time t_{off} when the control signal has a low level, the first transistor Q1 is turned off, and the signal level of the input/output line connected to the bi-directional port P is pulled up by the second pull-up resistor R2, and thus the high level signal is input to the bi-directional port. Accordingly, a signal having the same PWM waveform as the control signal and having the phase reversed (180° shifted) is input to the bi-directional port P. The second processor 200 may interpret the PWM duty ratio of the signal input through the bi-directional port P and control the target element according to the interpreted PWM duty ratio.

Next, the response phase is associated with the second transistor Q2.

In the response phase, the second processor 200 may check the open/closed state of the target element, set the second time period t_{low} to the first time (e.g., 100 ms) in the case of the open state, and set the second time period t_{low} to the second time (e.g., 150 ms) in the case of the closed state.

Thereafter, the second processor 200 may output the state signal through the bi-directional port P for the set first or second time. The level (size) of the state signal may be preset in the second processor 200 to a value within a range in which the first transistor Q1 maintains a turn-off state and the second transistor Q2 may be turned on. The state signal is input to the base terminal of the second transistor Q2 during the second time period (i.e., the set first time or second time), and thus the second transistor Q2 performs a turn-on operation. As a result, the communication bus B is grounded by the turn-on operation of the second transistor Q2, and thus the low-level signal (i.e., state information) is formed in the communication bus B during the second time period. The low-level signal (state information) maintained during the second time period is transmitted to the first processor 100.

According to the above operation, the bi-directional port P of the second processor 200 functions as a timer input module (TIM) during the first time period (monitoring phase) in which the control signal is input and functions as a data input/output (DIO) during the second time period (response phase) in which the state signal is output. The first time period may be preset in the second processor 200 according to the above-described protocol (e.g., PIM requirements according to the design specifications of the vehicle and battery system), so the second processor 200 may operate the bi-directional port P as the TIM during the first time period, and operate the bi-directional port P as the DIO during the second time period from a time point at which the first time period has elapsed.

As described above, the transistor-based arbitrator that arbitrates the first direction transmission (input) of the contactor control signal from the PIM bus to the MCU and the second direction transmission (output) of the contactor status signal from the MCU to the PIM bus adopts the method of performing inputting the contactor control signal applied to the PIM bus and outputting the contactor state information from the MCU to the PIM through the single bi-directional port provided in the MCU based on the topology connected between the PIM bus and the MCU. Thus it is possible to implement the hardwired contactor control using the single port of the MCU without being constrained by the restrictions on the number of ports of the MCU that may be required depending on the design specifications of the ECU and BMS.

Implementations described in the present specification may be implemented in, for example, a method or process, an apparatus, a software program, a data stream, and/or a signal. Although discussed only in the context of a single form of implementation (e.g., discussed only as a method), implementations of the discussed features may also be implemented in other forms (e.g., an apparatus or a program). The apparatus may be implemented in suitable hardware, software, and firmware, and the like. A method may be implemented in an apparatus such as a processor, which generally refers to a computer, a microprocessor, an integrated circuit, a processing device including a programmable logic device, or the like.

According to the present invention, a transistor-based arbitrator that arbitrates the first direction transmission (input) of a contactor control signal from the PIM bus to the MCU and the second direction transmission (output) of a contactor status signal from the MCU to the PIM bus adopts the method of performing inputting the contactor control signal applied to the PIM bus and outputting contactor state information from the MCU to the PIM through a single bi-directional port provided in the MCU based on a topology connected between the PIM bus and the MCU. Thus, it is possible to implement a hardwired contactor control using the single port of the MCU without being constrained by the restrictions on the number of ports of the MCU that can be required depending on the design specifications of the ECU and BMS.

However, effects that can be achieved through the present invention are not limited to the above-described effects and other effects that are not described may be clearly understood by those skilled in the art from the detailed descriptions.

Hereinabove, although the present invention has been described with reference to exemplary embodiments and the accompanying drawings, the present invention is not limited thereto, but may be variously modified and altered by those skilled in the art to which the present invention pertains without departing from the scope as defined by the appended claims.

## Claims

1. A bi-directional communication-based control apparatus comprising:
a processor (200) that controls a target element according to a control signal applied to a communication bus (B) and causes state information of the target element according to a result of the control to be formed on the communication bus (B), inputting the control signal and outputting a state signal for forming the state information being performed through a single bi-directional port (P) provided in the processor (200); and
an arbitrator (300) that arbitrates first direction transmission of the control signal from the communication bus (B) to the bi-directional port (P) and second direction transmission of the state signal from the bi-directional port (P) to the communication bus (B).

2. The bi-directional communication-based control apparatus of claim 1, wherein the processor (200) receives the control signal, which is applied to the communication bus (B) and has passed through the arbitrator (300) during a first time period, through the bi-directional port (P) and outputs the state signal to the arbitrator (300) during a second time period following the first time period to form the state information on the communication bus (B).

3. The bi-directional communication-based control apparatus of claim 2, wherein, as a predefined protocol is applied to the control signal and the state information, the control signal is formed as a pulse width modulation, PWM, signal during the first time period, and the state information is defined by a length of the second time period in which a signal level of the communication bus (B) is maintained at a low level.

4. The bi-directional communication-based control apparatus of claims 1, 2, or 3, wherein the arbitrator (300) includes a first transistor (Q1) that arbitrates the first direction transmission of the control signal, and a second transistor (Q2) that arbitrates the second direction transmission of the state signal.

5. The bi-directional communication-based control apparatus of claim 4, wherein a collector terminal of the first transistor (Q1) and a base terminal of the second transistor (Q2) are connected to the bi-directional port (P).

6. The bi-directional communication-based control apparatus of claim 5, wherein the arbitrator (300) further includes a resistor element (R2) having a one terminal connected to an internal power source and another terminal connected to the bi-directional port (P).

7. The bi-directional communication-based control apparatus of claim 5 or 6, wherein a base terminal and an emitter terminal of the first transistor (Q1) are connected to the communication bus (B) and a ground terminal, respectively.

8. The bi-directional communication-based control apparatus of any of claims 5 to 7, wherein during the first time period, as the control signal formed of the PWM signal is input to the base terminal of the first transistor (Q1) and the first transistor (Q1) performs an on-off operation according to the PWM signal, a signal having the same PWM waveform as the control signal is input to the bi-directional port (P) connected to the collector terminal of the first transistor (Q).

9. The bi-directional communication-based control apparatus of any of claims 6 to 8, wherein a collector terminal and an emitter terminal of the second transistor (Q2) are connected to the communication bus (B) and the ground terminal, respectively.

10. The bi-directional communication-based control apparatus of claim 9, wherein after the first time period, as the processor (200) inputs the state signal to the base terminal of the second transistor (Q2) during the second time period and the second transistor (Q2) performs an on operation, the state information is formed on the communication bus (B) connected to the collector terminal of the second transistor (Q2) during the second time period.

11. The bi-directional communication-based control apparatus of any of claims 1 to 10, wherein the processor (200) is implemented as a battery management system, BMS, or as a controller included in the BMS,
the communication bus (B) is connected to a vehicle controller (100) that functions as a high-level controller of the processor, and
the control signal is applied from the vehicle controller to the communication bus (B), and the state information formed on the communication bus (B) is transmitted to the vehicle controller (100).

12. The bi-directional communication-based control apparatus of claim 11, wherein the bi-directional port (P) functions as a timer input module, TIM, during a first time period in which the control signal is input and functions as a data input/output, DIO, during a second time period in which the state signal is output.

13. The bi-directional communication-based control apparatus of claim 12, wherein the first time period is preset in the processor (200) according to a predefined protocol, and
the processor (200) operates the bi-directional port (P) as the TIM during the first time period, and operates the bi-directional port (P) as the DIO during the second time period from a time point at which the first time period has elapsed.

14. A bi-directional communication interface comprising:
a single bi-directional port (P) that is provided in a processor (200) that controls a target element according to a control signal applied to a communication bus (B) and causes state information of the target element according to a result of the control to be formed on the communication bus (B), inputting the control signal and outputting a state signal being performed through the bi-directional port (P); and
an arbitrator (300) that arbitrates first direction transmission of the control signal from the communication bus (B) to the bi-directional port (P) and second direction transmission of the state information from the bi-directional port (P) to the communication bus (B).

15. A bi-directional communication-based control system comprising:
a first processor (100) configured to apply to a communication bus (B) a control signal for controlling a target element and receives state information of the target element formed on the communication bus (B);
a second processor (200) configured to control the target element according to the control signal applied to the communication bus (B) and cause state information of the target element according to a result of the control to be formed on the communication bus (B); and
an arbitrator (300) configured to arbitrate first direction transmission of the control signal from the communication bus (B) to the bi-directional port (P) and second direction transmission of the state signal from the bi-directional port (P) to the communication bus (B),
wherein inputting the control signal and outputting a state signal for forming the state information is performed through a single bi-directional port (P) provided in the second processor (200).
